Europäisches Patentamt

(19) European Patent Office

Office européen des brevets

(11) Publication number: **0 306 140**
**A1**

(12) **EUROPEAN PATENT APPLICATION**

(21) Application number: 88306816.5

(22) Date of filing: 25.07.88

(51) Int. Cl.⁴: **C23C 16/06 , C23C 16/30 , F16K 27/02**

(30) Priority: 28.07.87 US 78619

(43) Date of publication of application:
08.03.89 Bulletin 89/10

(84) Designated Contracting States:
**DE FR GB IT**

(71) Applicant: **MORTON THIOKOL, INC.**
**110 North Wacker Drive**
**Chicago Illinois 60606-1560(US)**

(72) Inventor: **Walsh, John J.**
**4201 Claremont Court**
**Wilmington Delaware 19808(US)**

(74) Representative: **Bankes, Stephen Charles**
**Digby et al**
**BARON & WARREN 18 South End Kensington**
**London W8 5BU(GB)**

(54) **Ultralightweight high operating temperature structures.**

(57) An ultralightweight high operating temperature structure made from a reticulated vitreous carbon foam material forming a honeycomb-like microstructure of open cells connected by solid vitreous carbon filaments as the substrate (10) for a uniform coating on the filaments of a refractory material such as rhenium to give the substrate (10) structural properties. Valve components (26) and the like fabricated in substrate form from the reticulated vitreous carbon foam material are covered with a sheath or skin (40) of a refractory material such as rhenium which seal the material for pressure as well as providing the surface finish requirements for mechanical interfaces and flow passages.

EP 0 306 140 A1

## ULTRALIGHTWEIGHT HIGH OPERATING TEMPERATURE STRUCTURES

## BACKGROUND OF THE INVENTION

### 1. Field of the Invention

This invention relates to a method of making ultralightweight non-outgassing self-supporting structures that are erosion resistant at high operating temperatures in the presence of corrosive gases. While not limited to such use, the invention has particular utility in enabling minimization of the inert weight of valves, thrusters, cases, insulation, etc. of space vehicles, including kinetic energy weapons, and in enabling the total integration of components and the elimination of interfaces.

### 2. Description of the Prior Art

Typically, the propulsion system for a kinetic energy weapon consists of valves, manifolds, cases, vehicle structure, propellant, and igniters. The function of the propulsion system is to provide maneuvering capability for a terminally guided kinetic energy weapon projectile for ballistic missile intercept. Weight is a critical factor in such systems. Thus, the projectile weight has a controlling effect on the design, weight, envelope and cost of all of the other components. Mass fractions of current state of the art systems of this type are about 0.25 to 0.33. "Mass fraction" is the ratio of the mass of the propellant grain in a rocket motor case to the total mass that could be put in the case if it were completely filled. In order to obtain higher mass fractions, it is necessary to minimize the inert weight of the propulsion system. In addition, the ability to totally integrate components and eliminate interfaces is desirable.

Prior art "hot gas" or high temperature valves used in propulsion systems for controlling the flow of corrosive gases at high temperatures conventionally are made of a carbon-carbon material. High temperature corrosive gases produced by energetic, that is, metallized propellants, cause valves made of such material to erode at an unacceptably high rate. Additionally, the use of carbon-carbon material in the fabrication of hot gas valves adds undesirably to the weight of the propulsion system and thus detracts from the mass fraction.

Known in the prior art is a lightweight open pore "foam" material of honeycomb microstructure form having a melting point of 6300° F. (3498.9° C.) that is composed of vitreous carbon. This material, which is called reticulated vitreous carbon, has exceptionally high void volume with high temperature strength combined with low bulk thermal conductivity. It is a chemically inert form of carbon and is characterized as being non-outgassing at high operating temperatures. Reticulated vitreous carbon is commercially available from Energy Research and Generation, Inc., Lowell and 57th Street, Oakland, California, 94608.

While having lightweight and high temperature operating characteristics in non-oxidizing atmospheres, reticulated vitreous carbon material offers no real physical properties which are required for propulsion subsystem structures such as valves, cases, manifolds and vehicle structure.

Thus, there is a need and a demand for improvement in the fabrication of propulsion subsystem and other structures to the end of achieving lightweight, and preferably ultralightweight, structures that are non-outgassing with little or no erosion at high operating temperatures. Such structures make possible the attainment of mass fractions of 0.60 to 0.80. The present invention was devised to fill the technological gap that has existed in the art in these respects.

## SUMMARY OF THE INVENTION

An object of the invention is to provide a method for fabricating ultralightweight structures exhibiting little or no erosion at high operating temperatures.

Another object of the invention is to provide a method for fabricating nonoutgassing ultralightweight structures that are characterized in having little or no erosion at high operating temperatures and high flow rates for use in the propulsion systems and vehicle structures of space vehicles and kinetic energy weapons.

A further object of the invention is to provide an ultralightweight structure characterized in its high resistance erosion at high operating temperatures that is fabricated by a process consisting of the steps of:

(a) fashioning into desired form a substrate of open pore foam reticulated vitreous carbon material having a structure of open cells connected by solid filaments, said substrate having predetermined surfaces;

(b) applying by chemical vapor deposition a coating of a first refractory material to the solid filaments of the reticulated vitreous carbon substrate to form a matrix of honeycomb-like tubular elements with the vitreous carbon filament being the core of each tubular element whereby said substrate is made to take on physical and thermal properties as a function of the amount of said first refractory material that is applied;

(c) applying by chemical vapor deposition a coating of a second refractory material to form a skin on selected ones of said predetermined surfaces of said substrate while masking those surfaces where a skin is not required, thereby imparting desired physical and thermal properties to said structure including the provision of any required pressure seal/permeability barrier; and

(d) processing said structure after the skin has been formed by grinding and coating reapplication of said second refractory material to obtain the desired surface finish and tolerances.

In accomplishing these and other objectives of the invention, reticulated vitreous carbon material is employed as a mandrel or mold upon which to apply other materials. Such other materials can be refractory metals, refractory carbides, refractory oxides, or engel-brewer compounds (mixtures of refractory materials) depending upon the application. The open-cell porosity of the reticulated vitreous carbon material lends itself to the use of chemical vapor deposition to apply a uniform coating of the selected other material to each carbon filament. This in effect forms a honeycomb-like tubular material matrix with the reticulated vitreous carbon filament being the core. As the selected material is applied, the structure begins to take on the properties required for the application as a function of the amount of material applied. This enables a design of ultralightweight honeycomb materials from the standpoint of physical and thermal properties required for a specific application.

Once the reticulated carbon filaments have been coated to give the bulk material the desired properties, a skin of material similar to the selected material or of different material can be put on specific surfaces. When doing this the surfaces where the skin is not required are masked. The skin, once applied, provides additional physical and thermal properties. In a propulsion system application, this provides the pressure seal/permeability barrier that is required. Processing of the structure after the skin has been applied can be done by grinding and coating reapplication to obtain the desired surface finish and tolerances.

The various features of novelty which characterize the invention are pointed out with particularity in the claims annexed to and forming a part of the specification. For a better understanding of the invention, its operating advantages, and specific objects attained by its use, reference is made to the accompanying drawings and descriptive matter in which a preferred embodiment of the invention is illustrated.


BRIEF DESCRIPTION OF THE DRAWINGS

With this description of the invention, a detailed description follows with reference being made to the accompanying figures of drawing which form part of the specification and of which:

Fig. 1 is a schematic drawing illustrating the formation of a blast tube by chemical vapor deposition of a refractory material on a tube-shaped mold or mandrel made of reticulated vitreous carbon foam material;

Fig. 2 illustrates the refractory coated blast tube formed by the arrangement of Fig. 1;

Fig. 3 illustrates a value actuation component formed by a chemical vapor deposition process similar to that described in Fig. 1 using reticulated vitreous carbon material as a mold or mandrel upon which to deposit a refractory material; and

Fig. 4 is a fragmented illustration partly in cross section of a valve body in which the valve actuation component of Fig. 3 may be employed and which also has been formed by a process similar to that described in Fig. 1.

## DESCRIPTION OF THE PREFERRED EMBODIMENTS

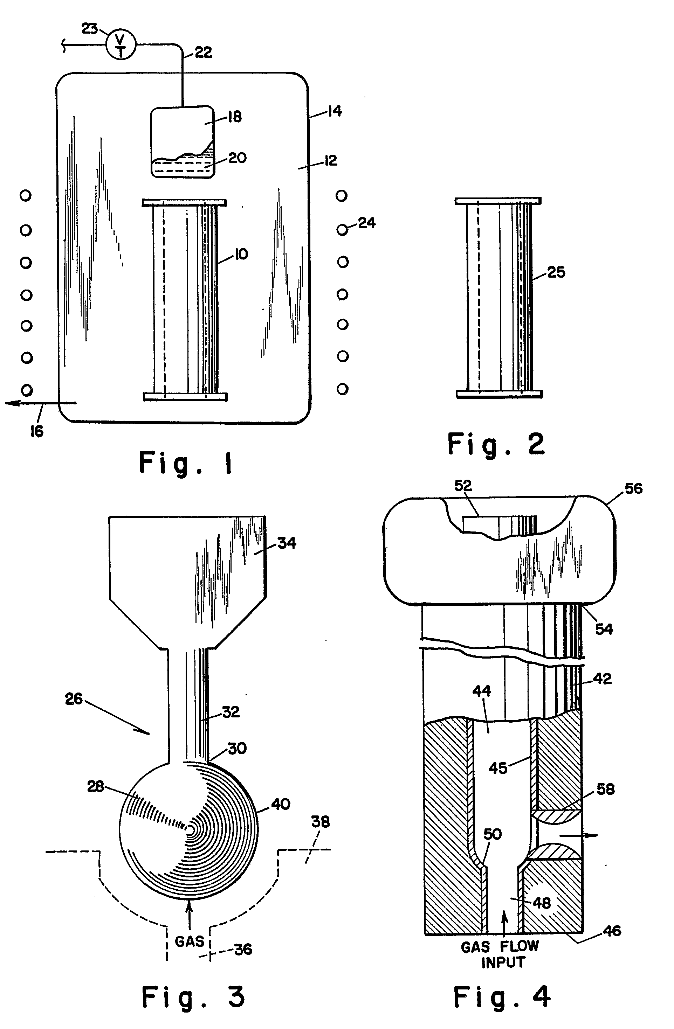

In Fig. 1 there is illustrated a method of fabricating an ultralightweight structure comprising a blast tube which involves the condensation of refractory material from the gaseous or vapor state to form solid structural deposits on an appropriately shaped mold or mandrel 10 which is made of reticulated vitreous carbon material. A blast tube is a hollow cylinder or tube which is used to connect a rocket motor case and nozzle when the case and nozzle must be separated by some distance, usually because of space vehicle design requirements.

The process illustrated in Fig. 1 utilizes a gaseous compound of the element to be deposited, for example, rhenium, having a melting temperature of 5756° F. (3180° C.) or other refractory metals or materials, such, for example, as hafnium carbide.

As shown in Fig. 1, the mold or mandrel 10, hereinafter termed "structure," is positioned in a reaction enclosure or chamber 12 which is defined by a wall 14 that preferably is made of quartz. Reaction chamber 12 is connected by a conduit 16 to a source (not shown) of vacuum pressure for the evacuation thereof. Chamber 12 is provided to isolate the structure 10 in a controlled environment and may include therein a turn table or other suitable holding mechanism (not shown) for supporting and rotating the structure 10.

Chamber 12 further includes therein a gaseous reducing agent chamber 18 for the refractory metal, designated 20, to be deposited, and a source (not shown) of gaseous agent, such, for example, as hydrogen or chlorine, that is connected to chamber 12 by a conduit 22. By way of example, and not limitation, it is noted that when the refractory metal to be vapor deposited is rhenium, the gaseous agent may be chlorine. Additionally, an induction coil 24, energized from a suitable source of alternating electrical current (not shown) is provided externally of the reaction chamber 12 for heating the structure 10 to a temperature of 2552° F. (1400° C.) Such heating is caused by the electrical resistivity of the structure 10 in the alternating electrical field.

In the chemical vapor deposition apparatus of Fig. 1, chlorine or other suitable gas is passed through the chamber 18. The refractory metal 20 in chamber 18 may be in pellet form. When heated to a suitable high temperature (by means not shown) there is a reaction between the metal 20 and the chlorine gas. This reaction, when the refractory metal is rhenium, for example, forms a gaseous mixture of rhenium pentachloride at a temperature of about 932° F. (500° C.). Since the reaction is exothermic, the chamber 18 needs only initial heating to start the reaction, the heat produced by the reaction being sufficient to sustain it.

As the gaseous mixture passes over the heated porous structure 10, it decomposes and infiltrates the structure 10. This results in the deposition of a uniform coating of rhenium metal on the solid carbon filaments that connect the reticulated cellular structure. Chlorine gas is released and it is evacuated from the chamber 12 through conduit 16. In order to control the uniformity of the coating on the solid carbon filaments, the chemical vapor deposition process may be interrupted and the structure 10 may be adjusted in position. Such adjustment may be utilized to move those portions of the structure 10 and the coating thereon which previously had been remote from the gaseous reducing agent chamber 18 closer thereto, thus tending to make more uniform the thickness of the coating that it deposited on the solid carbon filaments.

The chemical reactions that are involved in the chemical vapor deposition process taking place that results in the deposition of a coating of other refractory metals such as hafnium or refractory carbides or oxides are known to those skilled in the art, and therefore, will not further be described herein.

In accordance with the invention, the gaseous mixture from chamber 18 is passed sufficiently slowly over and infiltrates sufficiently slowly through the structure 10 that the rhenium metal is deposited on the solid reticulated carbon filaments to form a metallic coating thereon substantially throughout the entire structure. The structure 10 thus begins to take on properties desired for the blast tube structure 10 being formed as shown in Fig. 2, as a function of the amount of rhenium metal that is deposited.

When the reticulated carbon filaments have been coated to give the structure 10 the desired properties, a skin of the same, similar or different material can be put on the specific surfaces. This may be done by masking those surfaces where a "skin" is not required, as for example, by providing a barrier to block off the deposit of metal on such surfaces, in a manner known to those skilled in the art and not described in detail herein. The skin, once applied, provides additional physical and thermal properties required or desired for the blast tube structure 10. In addition, the skin provides a pressure seal/permeability barrier.

Further, in accordance with the invention, a coating or skin of rhenium metal may be formed on the surface of the structure 10 by increasing the rate at which the gaseous mixture from chamber 18 is passed over and through the structure 10. For facilitating adjustment in the rate at which the gaseous mixture from chamber 18 is passed over and through the structure 10, a suitable valve, designated 23 as seen in Fig. 1, may be provided in conduit 22. Upon increase in gaseous flow, the rhenium metal being deposited is produced at such a rapid rate that it gathers into cohering masses or globules that are too large to enter the open pores of the structure 10 and thus form a coating or skin on the surface thereof. With no masking provided for any of the surfaces, such a coating or skin, designated by reference number 25, is provided both internally and externally, of the blast tube structure 10; including suitable flanges that may be provided on the ends thereof, as shown in the drawings.

Processing after the skin has been applied can be accomplished by grinding, and if necessary, reapplication of an additional rhenium coating to obtain the desired surface finish and tolerance.

A small blast tube having a length of 3.1 inches and having internal and external diameters of and

$$O.D. = .83$$
$$I.D. = .375$$

inches, respectively, was fabricated in a manner substantially as described above with a 12-14 mil rhenium coating or skin on a reticulated vitreous carbon substrate. This blast tube was pressure leak tested at 1,000 pounds per square inch absolute (psia), and static tested flowing corrosive gases at a temperature of 4500° F. (2468° C.) at Mach 0.85 through it. The skin survived the test with an erosion rate of less than 0.1 mils/second which is well within acceptable limits.

It is noted that in the fabrication of the blast tube structure 10, the honeycomb microstructure 10 is employed as a substrate for a coating of rhenium which gives the substrate material structural properties or qualities. The rhenium coating, in addition, alters the radiative heat transport through the material by modifying the internal emissivity of the material, from filament to filament. It is believed that this reduces thermal transport through the material by approximately 70 percent and thus aids in solving the problems of thermal isolation. This is of especial importance in connection with valve actuation components of propulsion systems, particularly in respect of reducing valve interface problems. The rhenium coating or skin which is oxidation resistant seals the reticulated vitreous carbon substrate surface for pressure as well as providing the surface finish requirements for mechanical interface and flow passages.

In Fig. 3 of the drawings there is shown a valve actuation component 26 including a closure element or pilot valve substantially in the form of a ball 28. The ball 28 is fixedly attached at a first end of component 26 to the end 30 of a narrow part 32 thereof, between ball 28 and a valve piston 34 at a second end thereof.

Ball 28 is positioned adjacent a gas inlet opening 36, the cross section of which is circular, in a valve housing or body seat shown in phantom at 38. The diameter of the opening 36 may be substantially smaller, as shown, than the diameter of the ball 28.

The ball 28 and attached valve piston 34 may be fabricated by a process that is substantially the same as described in connection with Fig. 1 using a reticulated vitreous carbide (SiC) foam material substrate as a mold or mandrel upon which to apply other materials for the coating internally of the solid filaments and for providing a skin for covering external surfaces.

Completely covering and encasing the valve actuation component 26 is a 12-14 mil coating or skin of rhenium 40. The skin seals the surface of the reticulated vitreous carbon foam for pressure and also provides the required surface finish for mechanical interfaces with a valve housing and valve seat 38 with which the component 10 may be placed in operative relation.

In addition to giving the substrate of which component 26 is fabricated structural properties, the rhenium skin 40 modifies the emissivity of the reticulated carbon foam material. This substantially reduces thermal transport through the material with a reduction of approximately 70 percent being realizable, as mentioned above. Such significant reduction in thermal transport through the material aids in thermally isolating the valve actuation component 26, as well as reducing interface temperature problems of the component 26 with the valve seat 38 and with a valve housing 42 with which it may be operatively associated, as illustrated, for example, in Fig. 4.

The valve housing 42 shown in Fig. 4, similarly to the valve actuation component 26, is fabricated from a substrate comprising a reticulated vitreous carbon foam material. Covering and defining the inside wall of an elongated cavity or cylindrical chamber 44 of the housing 42 is a 12-14 mil coating 45 of rhenium. Chamber 44 extends for a substantial portion of the length of the housing 42 from a first end 46 thereof. At the end 46 a suitable fitting (not shown) may be provided for receiving a gas flow input 48. The configuration of chamber 44 is such as to provide a valve seat 50 at a location adjacent the valve housing end 46. Further inwardly, the dimensions of the chamber 44 are such as to receive the valve piston 34 of the valve actuation component 26 in sliding relation for seating of the ball 28 on the valve seat 50. A solenoid 52 positioned at a second end 54 of valve housing 42 and enclosed with a separable valve cap 56 may be provided for actuating the ball 28 into and out of seating relation with the valve seat 50, and thereby closing and opening the valve. The solenoid 52 may be connected to the valve actuation component 26 in a manner known to those skilled in the art. Such connection forms no part of the present invention, and therefore, is not described in detail herein.

Gas entering the gas flow input 48 and allowed to pass by the ball 28 is exhausted from the chamber 44 through a gas flow exhaust opening formed by a tubular member 58 that is positioned in the valve housing 42. Preferably, the inside wall of member 58 is provided with a rhenium or other similar high temperature resistant coating. Member 58 may be provided with a fitting (not shown) for the connection thereof to mechanism for utilizing the energy in the gas flow exhaust, for example, one or more rocket motor thrusters.

An evaluation of the weight of several valve components fabricated from rhenium coated reticulated vitreous carbon as compared with conventional carbon-carbon material hot gas valve components is given in the following Table. This Table demonstrates that the invention reduces the combined weight of the several components by 88 percent over the carbon-carbon components.

| COMPONENT | CARBON VALVE | SiC FOAM VALVE |
|---|---|---|
| Piston | 51.98 grams | 9.26 grams |
| Housing | 582.43 grams | 66.54 grams |
| Pilot valve | 130.15 grams | 17.23 grams |
| Cap | 79.61 grams | 11.66 grams |
| Total | 844.17 grams | 104.69 grams |

In addition, thermal isolation of exhaust gases is accomplished easily. This reduces valve size and minimizes design complexities associated with the isolation of valve actuation mechanisms.

Thus, in accordance with the invention, there has been provided a method for fabricating a unique, non-outgassing ultralightweight structure having little or no erosion at high operating temperatures in the presence of corrosive gases moving at high speed and having particular utility for use in propulsion systems and structures for space vehicles and kinetic energy weapons. Other potential applications for the ultralightweight structure are:

1. Machining valves, cases, thrusters and manifolds integrally to form integrated projectiles;
2. Lightweight high energy laser mirrors;
3. Advanced lightweight structures;
4. Non-outgassing high temperature insulation for rocket motor nozzle components and aerospace planes.

With this description of the invention in detail, those skilled in the art will appreciate that modification may be made to the invention without departing from the spirit thereof. Therefore, it is not intended that the scope of the invention be limited to the specific embodiment illustrated and described. Rather, it is by the scope of the appended claims.

## Claims

1. A method of fabricating an ultralightweight structure characterized in its high resistance to erosion at high operating temperatures consisting of the steps of:

(a) applying by chemical vapor deposition a coating of a first refractory material to the solid filaments that connect the cellular structure of an open pore reticulated vitreous carbon substrate having a plurality of predetermined surfaces to form a matrix of honeycomb-like tubular elements with a solid filament being the core of each tubular element whereby said substrate takes on physical and thermal desired properties desired for said structure as a function of the amount of said first material that is applied;

(b) applying by chemical vapor deposition a coating of a second refractory material on selected ones of said predetermined surfaces of said substrate to form a skin thereon and thereby impart desired physical and thermal properties to said structure; and

(c) processing said structure after formation of a skin thereon by grinding to obtain the desired surface finish and tolerances.

2. A method according to claim 1 wherein said coating of a second refractory material is applied to selected ones of said predetermined surfaces by masking those surfaces on which a skin is not to be formed.

3. A method according to claim 1 or claim 2 wherein in the application of said first and said second refractory materials to said substrate a heated gaseous mixture of each respective refractory material and an element that chemically reacts therewith is passed over said substrate;
wherein said substrate is heated;
wherein said substrate and the said gaseous mixtures are contained within a chamber to which vacuum pressure is applied;
wherein the gaseous mixture of said first refractory material is passed over said substrate at a rate sufficiently slow as to allow decomposition and infiltration thereof into the pores of said substrate and the deposition of said first refractory material on the solid filaments internally thereof; and
wherein the gaseous mixture of said second refractory material is passed over said substrate at a rate sufficiently fast to cause the second refractory material being deposited to be produced at such a rapid rate that it gathers into cohering masses that are too large to enter the pores of said substrate and thus forms a skin on the said selected ones of the predetermined surfaces thereof.

4. A method according to any preceding claim wherein said first and said second refractory materials are the same refractory material.

5. A method according to claim 4 wherein said first and said second refractory materials are both rhenium.

6. An ultralightweight structure made by a process according to any preceding claim, in the form of a blast tube.

7. An ultralightweight structure made by a process according to any one of claims 1 to 5, in the form of a valve actuation component.

8. An ultralightweight, high temperature gas valve comprising,
a valve actuation component (26),
a valve housing (42), said valve housing including a valve seat (50) and an elongated chamber (44) in which said valve actuation component is received in sliding relation for movement into and out of closing relationship with said valve seat,
said valve actuation component and said valve housing each being fabricated from a substrate individual thereto of recticulated vitreous carbon foam having an internal structure of open cells connected by solid vitreous carbon filaments, each of said substrates having predetermined surfaces and including a respectively associated coating of a first refractory material on said filaments and a respectively associated coating of a second refractory material on selected ones of said predetermined surfaces, said coatings (40,45) of said second refractory material sealing said valve actuation component substrate and the chamber wall of said valve housing substrate for gas pressure and providing the surface finish for the mechanical interface between said valve actuating component and said valve housing chamber and valve seat.

9. An ultralightweight, high temperature gas valve as defined in claim 8 wherein said valve actuation component includes a first end and a second end with a ball portion (28) at said first end and a piston portion (34) at said second end, and
wherein said chamber (44) is cylindrical;
said piston portion being received in sliding relation in said chamber for movement of said ball portion into and out of closing relationship with said valve seat.

10. An ultralightweight high temperature gas valve as defined in claim 9 further including means (52) to control the movement of said valve actuation component in said chamber of said valve housing.

11. An ultralightweight high temperature gas valve as defined in any one of claims 8 to 10 further including a gas flow inlet opening (48) in said valve housing to said valve seat and a gas flow exhaust opening (58) from said chamber with a coating of said second refractory material on the chamber wall of said valve housing substrate extending to and covering said gas flow inlet opening and said gas flow exhaust opening.

12. An ultralightweight, high temperature gas valve as defined in claim 11 wherein each of said coatings of refractory material is a coating of rhenium.

13. An ultralightweight, high temperature gas valve as defined in claim 12 wherein said rhenium coating on the selected ones of said predetermined surfaces is 12-14 mil (305-356 μm) thick.

14. An ultralightweight, high operating temperature structure made from a substrate of reticulated vitreous carbon foam having an internal structure of open cells connected by solid vitreous carbon filaments, said substrate having predetermined surfaces and including a respectively associated coating of a first refractory material on said filaments and a respectively associated coating of a second refractory material on selected ones of said predetermined surfaces, said coatings of said second refractory material sealing said substrate for gas pressure and providing a surface finish for the mechanical interface with another high operating temperature component.

Fig. 1

Fig. 2

Fig. 3

Fig. 4

| | DOCUMENTS CONSIDERED TO BE RELEVANT | | EP 88306816.5 |
|---|---|---|---|

| Category | Citation of document with indication, where appropriate, of relevant passages | Relevant to claim | CLASSIFICATION OF THE APPLICATION (Int. Cl.4) |
|---|---|---|---|
| A | US - A1 - 4 576 836 (ROBERT CALMET et al.) <br> * Totality * <br> -- | | C 23 C 16/06 <br> C 23 C 16/30 <br> F 16 K 27/02 |
| A | DE - A1 - 2 446 790 (BUTZE-WERKE AG) <br> * Totality * <br> -- | | |
| A | EP - A2 - 0 060 726 (NORMALAIR-GARRETT) <br> * Totality * <br> -- | | |
| A | US - A1 - 4 393 097 (TOSHIO MIRAI, TAKASHI GOTO) <br> * Totality * <br> ---- | | |
| | | | **TECHNICAL FIELDS SEARCHED (Int. Cl.4)** |
| | | | C 04 B 38/00 <br> C 04 B 41/00 <br> C 23 C 16/00 <br> F 16 K 27/00 <br> F 42 B 15/00 |

The present search report has been drawn up for all claims

| Place of search | Date of completion of the search | Examiner |
|---|---|---|
| VIENNA | 14-12-1988 | KALANDRA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82